# EUROPEAN PATENT APPLICATION

(11) **EP 4 654 328 A2**
(43) Date of publication of application: **26.11.2025**
(21) Application number: 25208771.3
(22) Date of filing: 14.02.2022
(51) Int. Cl.: H01M 10/42

(54) **BATTERY MANAGEMENT APPARATUS**

(30) Priority: 22.02.2021 KR 20210023639
(62) Divisional of application: 22756440.8
(71) Applicant: LG Energy Solution, Ltd., Seoul 07335 (KR)
(72) Inventor: KANG, Yeong Ju, 34122 Daejeon (KR); KIM, Tae Soo, 34122 Daejeon (KR); JANG, Man Hoo, 34122 Daejeon (KR)
(74) Representative: Goddar, Heinz J.

(57) **Abstract**

A battery management apparatus according to an embodiment disclosed herein includes a shunt resistor connected to a battery and a voltage generation unit configured to generate a first output value and a second output value which have a difference therebetween corresponding to a magnitude of a voltage applied to the shunt resistor, in which the difference between the first output value and the second output value corresponds to the magnitude of the voltage applied to the shunt resistor when charging over-current or discharging over-current flows in the shunt resistor.

## Description

### [Technical Field]

### CROSS-REFERENCE TO RELATED APPLICATION

This application claims priority to and the benefit of Korean Patent Application No. 10-2021-0023639 filed in the Korean Intellectual Property Office on February 22, 2021, the entire contents of which are incorporated herein by reference.

### TECHNICAL FIELD

The present disclosure relates to a battery management apparatus.

### [Background Art]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Meanwhile, when over-current flows in the case of charging or discharging of a lithium-ion battery, the internal temperature of the battery increases, leading to a fire in a vehicle equipped with the battery. To prevent this situation, an over-current detection function for continuously determining whether the over-current flows in the battery is required, and the operational integrity of the over-current detection function also has to be guaranteed.

### [Disclosure]

### [Technical Problem]

Embodiments disclosed herein aim to provide a battery management apparatus capable of diagnosing an operation of an over-current detection function of a battery.

Technical problems of the embodiments disclosed herein are not limited to the above-described technical problems, and other unmentioned technical problems would be clearly understood by one of ordinary skill in the art from the following description.

### [Technical Solution]

A battery management apparatus according to an embodiment disclosed herein includes a shunt resistor connected to a battery and a voltage generation unit configured to generate a first output value and a second output value which have a difference therebetween corresponding to a magnitude of a voltage applied to the shunt resistor, in which the difference between the first output value and the second output value corresponds to the magnitude of the voltage applied to the shunt resistor when charging over-current or discharging over-current flows in the shunt resistor.

In an embodiment, the voltage generation unit may be further configured to generate the first output value and the second output value in a state where the charging over-current or the discharging over-current does not flow in the shunt resistor.

In an embodiment, the voltage generation unit may be further configured to generate the first output value that is a difference between the magnitude of the voltage applied to the shunt resistor and a voltage of the battery when the charging over-current flows in the shunt resistor, and to generate the second output value that is equal to the voltage of the battery.

In an embodiment, the voltage generation unit may be further configured to generate the first output value that is equal to the voltage of the battery and to generate the second output value that is a difference between the voltage applied to the shunt resistor and the voltage of the battery when the discharging over-current flows in the shunt resistor.

In an embodiment, the battery management apparatus may further include a determination unit configured to receive the first output value and the second output value and to determine whether the charging over-current or the discharging over-current flows in the shunt resistor.

In an embodiment, the determination unit may include an amplifier configured to receive and amplify the first output value and the second output value, a comparator configured to compare an output of the amplifier with a reference value, and a controller configured to determine whether the charging over-current or the discharging over-current flows in the shunt resistor, based on the output of the amplifier or the comparator.

In an embodiment, the voltage generation unit may include a plurality of resistors and a plurality of switches, and the plurality of switches may include any one of a negative-positive-negative (NPN)-type bipolar junction transistor (BJT), a positive-negative-positive (PNP)-type BJT, and a metal-oxide-semiconductor field-effect transistor (MOSFET).

A battery management apparatus according to an embodiment disclosed herein includes a shunt resistor connected to a battery, a first resistor connected to the shunt resistor at a first node, a second resistor connected to the first resistor at a second node, a third resistor connected to the shunt resistor at a third node, a fourth resistor connected to the third resistor at a fourth node, a first switch connected to the second resistor, a second switch connected to the fourth resistor, and a determination unit configured to receive a voltage of the second node and a voltage of the fourth node and to determine whether over-current flows in the shunt resistor.

In an embodiment, the determination unit may include an amplifier configured to receive the voltage of the second node and the voltage of the fourth node and to amplify a difference therebetween, a comparator configured to compare an output of the amplifier with a reference value, and a controller configured to determine whether the charging over-current or the discharging over-current flows in the shunt resistor, based on the output of the amplifier or the comparator.

In an embodiment, the controller may be further configured to control the first switch and the second switch, to short-circuit the first switch and to open the second switch to detect the charging over-current, and to short-circuit the second switch and to open the first switch to detect the discharging over-current.

In an embodiment, the controller may be further configured to open both the first switch and the second switch in a situation where the battery is charged or discharged.

In an embodiment, the battery management apparatus may further include a relay connected to the shunt resistor, in which the relay is controlled by a control signal of the controller, and the controller is further configured to open the relay when the first switch or the second switch is short-circuited.

In an embodiment, the first switch and the second switch may include any one of a PNP-type BJT, an NPN-type BJT, and a MOSFET.

In an embodiment, magnitudes of the first resistor and the second resistor may be set such that a difference between a magnitude of the voltage of the second node and a magnitude of the voltage of the battery corresponds to the magnitude of the voltage applied to the shunt resistor when the over-current flows during charging of the battery, and magnitudes of the third resistor and the fourth resistor may be set such that a difference between a magnitude of the voltage of the fourth node and the magnitude of the voltage of the battery corresponds to the magnitude of the voltage applied to the shunt resistor when the over-current flows during discharging of the battery.

### [Advantageous Effects]

The battery management apparatus according to an embodiment disclosed herein may diagnose an operation of an over-current detection function of a battery.

### [Description of Drawings]

FIG. 1 illustrates a battery pack according to an embodiment disclosed herein.
FIGS. 2 and 3 illustrate a battery management system according to embodiments disclosed herein.
FIG. 4 is a view for describing in detail a voltage generation unit in a battery management system, according to an embodiment disclosed herein.
FIG. 5 is a view for describing a determination unit in a battery management apparatus, according to an embodiment disclosed herein.

### [Mode for Invention]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

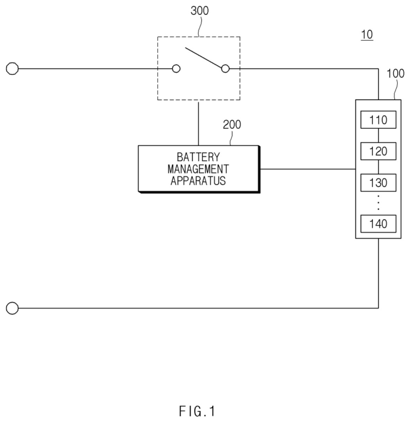

FIG. 1 illustrates a battery pack according to an embodiment disclosed herein.

Referring to FIG. 1, a battery pack 10 according to an embodiment disclosed herein may include a battery module 100, a battery management apparatus 200, and a relay 300.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number greater than or equal to 2). The battery module 100 may supply power to a target device (not shown). To this end, the battery module 100 may be electrically connected to the target device. Herein, the target device may include an electrical, electronic, or mechanical device that operates by receiving power from the battery pack 10 including the plurality of battery cells 110, 120, 130, and 140, and the target device may be, for example, an electric vehicle (EV), but is not limited thereto.

The plurality of battery cells 110, 120, 130, and 140 may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery management apparatus 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

In addition, the battery management apparatus 200 may monitor a voltage, a current, a temperature, an insulation resistance, etc., of the battery pack 10, the battery module 100 and/or each of the plurality of battery cells 110, 120, 130, and 140 included in the battery module 100. A sensor or various measurement modules for monitoring performed by the battery management apparatus 200, which are not shown, may be additionally installed in a charging/discharging path, any position of the battery module 100, etc. The battery management apparatus 200 may calculate a parameter indicating a state of the battery module 100, e.g., a state of charge (SOC), a state of health (SOH) etc., based on a measurement value such as monitored voltage, current, temperature, etc.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 10.

The battery management apparatus 200 may diagnose whether an over-current detection function operates normally. To this end, the battery management apparatus 200 may detect whether over-current flows in the battery module 100 when the battery module 100 is charged or discharged. The battery management apparatus 200 may open the relay 300 when the over-current is detected in the battery module 100. Thus, the battery management apparatus 200 may determine whether the over-current detection function operates normally, and may improve ISO26262 and an Automotive Safety Integrity Level (ASIL) safety level.

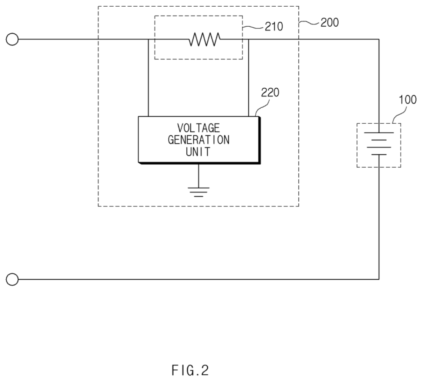

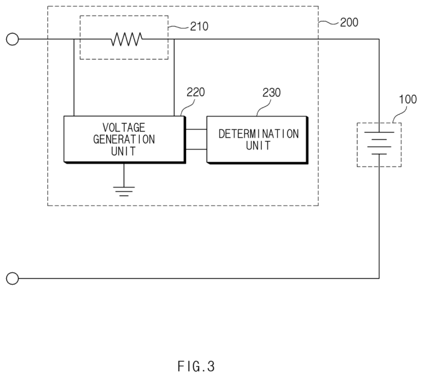

Hereinbelow, a detailed operation of the battery management apparatus 200 will be described with reference to FIGS. 2 and 3.

FIGS. 2 and 3 illustrate a battery management system according to an embodiment disclosed herein.

Referring to FIG. 2, the battery management apparatus 200 according to an embodiment disclosed herein may include a shunt resistor 210 and a voltage generation unit 220.

The shunt resistor 210 may sense current flowing in a circuit. For example, by measuring a voltage applied to the shunt resistor 210 with respect to current flowing in the circuit, the magnitude of the current flowing in the circuit may be sensed. The shunt resistor 210 may be connected to the battery module 100.

The voltage generation unit 220 may generate a first output value and a second output value. The voltage generation unit 220 may be connected to both terminals of the shunt resistor 210. The voltage generation unit 220 may generate the first output value and the second output value which have a difference therebetween corresponding to a magnitude of the voltage applied to the shunt resistor 210 when charging over-current or discharging over-current flows in the shunt resistor 210. That is, the difference between the first output value and the second output value may correspond to the magnitude of the voltage applied to the shunt resistor 210 when the charging over-current or the discharging over-current flows in the shunt resistor 210.

According to an embodiment, the voltage generation unit 220 may generate the first output value and the second output value when the charging over-current or the discharging over-current does not flow in the shunt resistor 210. For example, the battery management apparatus 200 may diagnose a charging over-current or discharging over-current detection function based on the first output value and the second output value that are generated when the charging over-current or the discharging over-current does not flow in the shunt resistor 210.

Herein, the charging over-current may be defined as over-current that flows in the battery module 100, a circuit connected to the battery module 100, and/or a device connected to the battery module 100 during charging of the battery module 100. Moreover, the discharging over-current may be defined as over-current that flows in the battery module 100, a circuit connected to the battery module 100, and/or a device connected to the battery module 100, etc., during discharging of the battery module 100. For example, in the battery management apparatus 200, levels of charging over-current and discharging over-current may be preset values.

According to an embodiment, the voltage generation unit 220 may generate a first output value that is a difference between a magnitude of the voltage applied to the shunt resistor 210 and a voltage of a battery when the charging over-current flows in the shunt resistor 210. For example, the voltage generation unit 220 may generate a first output value that is less than the magnitude of the voltage of the battery module 100 by the magnitude of the voltage applied to the shunt resistor 210 when the charging over-current flows in the shunt resistor 210. That is, the first output value may be obtained by subtracting the magnitude of the voltage applied to the shunt resistor 210 from the voltage of the battery module 100 when the charging over-current flows in the shunt resistor 210. Moreover, the voltage generation unit 220 may generate a second output value that is equal to the voltage of the battery. For example, the voltage generation unit 220 may generate the second output value having a magnitude corresponding to the magnitude of the voltage of the battery module 100.

The battery management apparatus 200 may detect the charging over-current based on the first output value and the second output value that are generated in the voltage generation unit 220.

According to an embodiment, the voltage generation unit 220 may generate the second output value that is equal to the voltage of the battery. For example, the voltage generation unit 220 may generate the first output value having a magnitude corresponding to the magnitude of the voltage of the battery module 100. In addition, the voltage generation unit 220 may generate the second output value that is a difference between the voltage applied to the shunt resistor 210 and the voltage of the battery when the discharging over-current flows in the shunt resistor 210. For example, the voltage generation unit 220 may generate the second output value that is less than the magnitude of the voltage of the battery module 100 by the magnitude of the voltage applied to the shunt resistor 210 when the discharging over-current flows in the shunt resistor 210. That is, the second output value may be obtained by subtracting the magnitude of the voltage applied to the shunt resistor 210 from the voltage of the battery module 100 when the discharging over-current flows in the shunt resistor 210.

The battery management apparatus 200 may detect the discharging over-current based on the first output value and the second output value that are generated in the voltage generation unit 220.

Meanwhile, according to an embodiment, the voltage generation unit 220 may be implemented with a plurality of resistors and a plurality of switches. For example, the plurality of switches may be any one of a negative-positive-negative (NPN)-type bipolar junction transistor (BJT), a positive-negative-positive (PNP)-type BJT, and a metal-oxide-semiconductor field-effect transistor (MOSFET).

Referring to FIG. 3, the battery management apparatus according to an embodiment disclosed herein may further include a determination unit 230 in addition to the shunt resistor 210 and the voltage generation unit 220.

The determination unit 230 may determine whether the over-current flows in the shunt resistor 210, based on the first output value and the second output value generated in the voltage generation unit 220. That is, in a situation where the charging over-current or the discharging over-current does not directly flow in the shunt resistor 210, the voltage generation unit 220 may generate the applied voltage when the charging over-current or the discharging over-current flows in the shunt resistor 210, and the determination unit 230 may receive the generated first output value and second output value and determine whether the over-current flows in the shunt resistor 210.

Thus, it may be diagnosed whether the determination unit 230 normally performs the over-current detection function. For example, when the determination unit 230 fails to determine that the over-current flows in the shunt resistor 210 in spite of reception of the first output value and the second output value from the voltage generation unit 220, it may be diagnosed that the determination unit 230 fails to normally perform the over-current detection function.

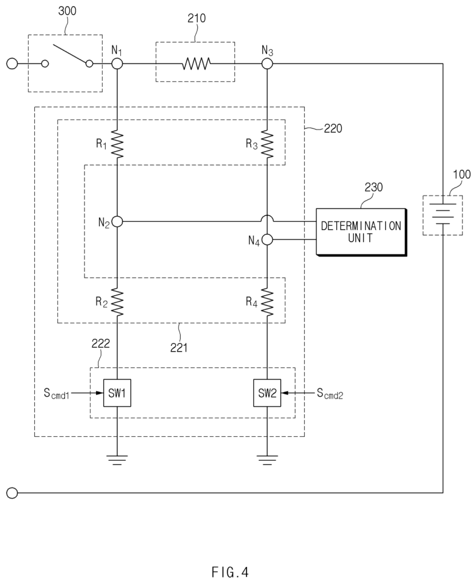

The voltage generation unit 220 in the battery management apparatus 200 will now be described in detail with reference to FIG. 4.

FIG. 4 is a view for describing in detail a voltage generation unit in a battery management system, according to an embodiment disclosed herein.

Referring to FIG. 4, the voltage generation unit 220 according to an embodiment disclosed herein may include the plurality of resistors 221 and the plurality of resistors 222.

The plurality of resistors 221 (R₁, R₂, R₃, and R₄) may be connected to both terminals of the shunt resistor 210. More specifically, the first resistor R₁ may be connected to the shunt resistor 210 at a first node N₁. The second resistor R₂ may be connected to the first resistor R₁ at a second node N₂. The third resistor R₃ may be connected to the shunt resistor 210 at a third node N₃. The fourth resistor R₄ may be connected to the third resistor R₃ at a fourth node N₄.

The values of the plurality of resistors 221 may be set to distribute the voltage of the battery module 100 based on the levels of the charging over-current and the discharging over-current.

For example, the magnitudes of the first resistor R₁ and the second resistor R₂ may be set such that a difference between the magnitude of the voltage applied to the second node N₂ and the magnitude of the voltage of the battery module 100 corresponds to the magnitude of the voltage applied to the shunt resistor 210 when the charging over-current flows in the shunt resistor 210. Moreover, the magnitudes of the third resistor R₃ and the fourth resistor R₄ may be set such that a difference between the magnitude of the voltage applied to the fourth node N₄ and the magnitude of the voltage of the battery module 100 corresponds to the magnitude of the voltage applied to the shunt resistor 210 when the discharging over-current flows in the shunt resistor 210.

Meanwhile, it is shown in FIG. 4 that the plurality of resistors 221 includes the first resistor R₁, the second resistor R₂, the third resistor R₃, and the fourth resistor R₄, the present disclosure is not limited thereto. For example, at least one of the first resistor R₁, the second resistor R₂, the third resistor R₃, and the fourth resistor R₄ may include a plurality of resistors.

The plurality of switches 222 (SW1 and SW2) may be connected to the plurality of resistors 221, respectively. More specifically, the first switch SW1 may be connected to the second resistor R₂, and the second switch SW2 may be connected to the fourth resistor R₄.

Meanwhile the plurality of switches 222 may be any one of a PNP-type BJT, an NPN-type BJT, and a MOSFET. For example, the plurality of switches 222 may be a PNP-type BJT.

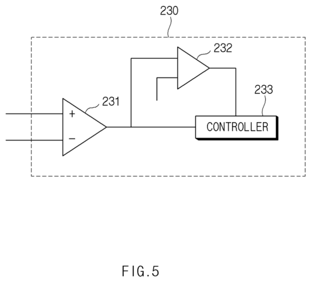

The plurality of switches 222 may be controlled by control signals S_{cmd1} and S_{cmd2}. For example, the first switch SW1 may be controlled by the first control signal S_{cmd1}, and the second switch SW2 may be controlled by the second control signal S_{cmd2}. The control signals S_{cmd1} and S_{cmd2} may be generated in a controller 233 (see FIG. 5). However, the present disclosure is not limited thereto, and a first controller and a second controller may exist to generate the first control signal S_{cmd1} and the second control signal S_{cmd2}, respectively, to control the first switch SW1 and the second switch SW2.

The controller 233 may short-circuit the first switch SW1 and open the second switch SW2 to detect the charging over-current. Moreover, the controller 233 may short-circuit the second switch SW2 and open the first switch SW1 to detect the discharging over-current.

When the battery module 100 is charged or discharged, the first switch SW1 and the second switch SW2 may be opened by the control signals S_{cmd1} and S_{cmd2}. When the first switch SW1 and the second switch SW2 are opened, the voltage of the first node N₁ may be applied to the second node N₂ and the voltage of the third node N₃ may be applied to the fourth node N₄, such that the determination unit 230 may receive the magnitude of the voltage applied to the both terminals of the shunt resistor 210. That is, the determination unit 230 may determine whether the charging over-current or the discharging over-current flows in the shunt resistor 210 when the battery module 100 is charged or discharged.

The determination unit 230 may receive the voltages applied to the second node N₂ and the fourth node N₄ and determine whether the charging over-current or the discharging over-current flows in the shunt resistor 210, based on the received voltages. That is, the battery management apparatus 200 may determine whether the determination unit 230 normally operates based on the voltages distributed to the second node N2 and the fourth node N4 in a situation where the charging over-current or the discharging over-current does not directly flow in the shunt resistor 210.

The determination unit 230 will now be described in detail with reference to FIG. 5.

FIG. 5 is a view for describing a determination unit in a battery management apparatus, according to an embodiment disclosed herein.

Referring to FIG. 5, in the battery management apparatus 200 according to an embodiment disclosed herein, the determination unit 230 may include an amplifier 231, a comparator 232, and a controller 233.

The amplifier 231 may amplify the difference between the first output value and the second output value delivered from the voltage generation unit 220. For example, the amplifier 231 may amplify a value obtained by subtracting the second output value from the first output value. The amplifier 231 may include an operational amplifier (OP-AMP).

For example, the amplifier 231 may receive the voltages applied to the second node N₂ and the fourth node N₄. In this case, the magnitude of the voltage of the second node N₂ may correspond to the first output value, and the magnitude of the voltage of the fourth node N₄ may correspond to the second output value.

The comparator 232 may receive an output of the amplifier 231 to compare the received output with a reference value, and output a comparison result. For example, when the output of the amplifier 231 is greater than the reference value, the comparator 232 may output a first value, and when the output of the amplifier 231 is less than the reference value, the comparator 232 may output a second value. Herein, the reference value may be set equally or differently according to when the charging over-current is detected and when the discharging over-current is detected.

The controller 233 may receive the output of the amplifier 231 and convert the received output into a digital signal, and compare the digital signal with a preset value to determine whether the charging over-current or the discharging over-current flows in the shunt resistor 210. The controller 233 may determine whether the charging over-current or the discharging over-current flows in the shunt resistor 210, based on the output of the amplifier 231, when both the first switch SW1 and the second switch SW2 are opened. For example, the controller 233 may be implemented with a microcontroller or an analog-to-digital converter (ADC) that receives the output of the amplifier 231.

Moreover, the controller 233 may determine whether the charging over-current or the discharging over-current flows in the shunt resistor 210, based on a comparison result output from the comparator 232. For example, the controller 233 may determine that the charging over-current flows in the shunt resistor 210, when the comparison result has a first value. That is, the controller 233 may determine whether the charging over-current or the discharging over-current flows in the shunt resistor 210, based on the comparison result of the comparator 232, when the first switch SW1 or the second switch SW2 is short-circuited.

Meanwhile, the controller 233 may generate a control signal for controlling the plurality of switches 222. For example, the controller 233 may generate the first control signal S_{cmd1} to control the first switch SW1, and may generate the second control signal S_{cmd2} to control the second switch SW2.

As a result, the controller 233 may determine whether the amplifier 231 and the comparator 232 operate normally, based on the first output value and the second output value input from the voltage generation unit 220, in a situation where the over-current does not flow in the shunt resistor 210. That is, the battery management apparatus 200 may guide a user when a charging over-current or discharging over-current detection function does not operate normally. In this way, it may be diagnosed whether the determination unit 230 normally performs the over-current detection function.

Meanwhile, the controller 233 may open the relay 300 when the battery module 100 is not charged or discharged. For example, the controller 233 may generate a control signal for opening the relay 300.

The controller 233 may generate the control signals S_{cmd1} and S_{cmd2} in a state where the relay 300 is opened, to alternately short-circuit the first switch SW1 and the second switch SW2, thus diagnosing whether the charging over-current detection function or the discharging over-current detection function operates.

Hereinbelow, diagnosis of the over-current detection function among operations of the circuit will be described based on a structure of the battery management apparatus 200.

As described above, the battery management apparatus 200 according to an embodiment disclosed herein may diagnose the over-current detection function. The battery management apparatus 200 may open the relay 300 and perform diagnosis of the charging over-current or discharging over-current detection function when the battery module 100 is not charged or discharged.

The battery management apparatus 200 may diagnose the charging over-current detection function. To diagnose the charging over-current detection function, the controller 233 may generate the plurality of control signals S_{cmd1} and S_{cmd2} to short-circuit the first switch SW1 and open the second switch SW2. When the first switch SW1 is short-circuited, the voltage of the battery module 100 may be distributed by the shunt resistor 210, the first resistor R₁, and the second resistor R₂, and the distributed voltage may be applied to the second node N₂. However, the magnitude of the voltage applied to the shunt resistor 210 may be much less than those of the voltages applied to the first resistor R₁ and the second resistor R₂. When the second switch SW2 is opened, the voltage of the battery module 100 may be applied to the fourth node N₄.

As described above, the magnitudes of the first resistor R₁ and the second resistor R₂ may be set such that a difference between the voltage applied to the second node N₂ and the voltage of the battery module 100 corresponds to the magnitude of the voltage applied to the shunt resistor 210 when the charging over-current flows in the shunt resistor 210. The voltage applied to the second node N₂ and the voltage applied to the fourth node N₄ may be input to the amplifier 231, and the amplifier 231 may amplify a difference between the voltage applied to the second node N₂ and the voltage applied to the fourth node N₄ and the amplified voltage may be input to the comparator 232. The comparator 232 may compare the magnitude of the amplified voltage with a first reference value. The output of the comparator 232 may be input to the controller 233, and the controller 233 may determine whether the charging over-current flows in the shunt resistor 210, based on the output of the comparator 232.

That is, the difference between the voltage applied to the second node N₂ and the voltage applied to the fourth node N₄ corresponds to the magnitude of the voltage applied to the shunt resistor 210 when the charging over-current flows in the shunt resistor 210, such that the battery management apparatus 200 may diagnose an operation of the charging over-current detection function in a situation where the charging over-current does not directly flow in the shunt resistor 210.

The battery management apparatus 200 may diagnose the discharging over-current detection function. To diagnose the discharging over-current detection function, the controller 233 may generate the plurality of control signals S_{cmd1} and S_{cmd2} to open the first switch SW1 and short-circuit the second switch SW2. When the second switch SW2 is short-circuited, the voltage of the battery module 100 may be distributed by the third resistor R₃ and the fourth resistor R₄, and the distributed voltage may be applied to the fourth node N₄. When the first switch SW1 is opened, the voltage of the battery module 100 may be applied to the second node N₂.

As described above, the magnitudes of the third resistor R₃ and the fourth resistor R₄ may be set such that a difference between the voltage applied to the fourth node N₄ and the voltage of the battery module 100 corresponds to the magnitude of the voltage applied to the shunt resistor 210 when the discharging over-current flows in the shunt resistor 210. The voltage applied to the second node N₂ and the voltage applied to the fourth node N₄ may be input to the amplifier 231, and the amplifier 231 may amplify the difference between the voltage applied to the second node N₂ and the voltage applied to the fourth node N₄ and the amplified voltage may be input to the comparator 232 for comparison with a second reference value. The output of the comparator 232 may be input to the controller 233, and the controller 233 may determine whether the discharging over-current flows in the shunt resistor 210, based on the output of the comparator 232.

That is, the difference between the voltage applied to the second node N₂ and the voltage applied to the fourth node N₄ corresponds to the magnitude of the voltage applied to the shunt resistor 210 when the discharging over-current flows in the shunt resistor 210, such that the battery management apparatus 200 may diagnose an operation of the discharging over-current detection function in a situation where the discharging over-current does not directly flow in the shunt resistor 210.

As described above, the battery management apparatus 200 may diagnose the operation of the charging over-current or discharging over-current detection function in a situation where the charging over-current or the discharging over-current does not directly flow in the shunt resistor 210. Thus, the battery management apparatus 200 may identify the integrity of the over-current detection function.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure. In view of the above, the present invention can be implemented according to the following itemized examples.

### [ITEM 1]

A battery management apparatus comprising:
a shunt resistor connected to a battery; and
a voltage generation unit configured to generate a first output value and a second output value which have a difference therebetween corresponding to a magnitude of a voltage applied to the shunt resistor,
wherein the difference between the first output value and the second output value corresponds to the magnitude of the voltage applied to the shunt resistor when charging over-current or discharging over-current flows in the shunt resistor.

### [ITEM 2]

The battery management apparatus of ITEM 1, wherein the voltage generation unit is configured to generate the first output value and the second output value in a state where the charging over-current or the discharging over-current does not flow in the shunt resistor.

### [ITEM 3]

The battery management apparatus of ITEM 1, wherein the voltage generation unit is configured to generate the first output value that is a difference between the magnitude of the voltage applied to the shunt resistor when the charging over-current flows in the shunt resistor and a voltage of the battery, and to generate the second output value that is equal to the voltage of the battery.

### [ITEM 4]

The battery management apparatus of ITEM 1, wherein the voltage generation unit is configured to generate the first output value that is equal to the voltage of the battery and to generate the second output value that is a difference between the voltage applied to the shunt resistor when the discharging over-current flows in the shunt resistor and the voltage of the battery.

### [ITEM 5]

The battery management apparatus of ITEM 1, further comprising a determination unit configured to receive the first output value and the second output value and to determine whether the charging over-current or the discharging over-current flows in the shunt resistor.

### [ITEM 6]

The battery management apparatus of ITEM 5, wherein the determination unit comprises:
an amplifier configured to receive and amplify the first output value and the second output value;
a comparator configured to compare an output of the amplifier with a reference value; and
a controller configured to determine whether the charging over-current or the discharging over-current flows in the shunt resistor, based on the output of the amplifier or the comparator.

### [ITEM 7]

The battery management apparatus of ITEM 1, wherein the voltage generation unit comprises a plurality of resistors and a plurality of switches, and the plurality of switches comprise any one of a negative-positive-negative (NPN)-type bipolar junction transistor (BJT), a positive-negative-positive (PNP)-type BJT, and a metal-oxide-semiconductor field-effect transistor (MOSFET).

### [ITEM 8]

A battery management apparatus comprising:
a shunt resistor connected to a battery;
a first resistor connected to the shunt resistor at a first node;
a second resistor connected to the first resistor at a second node;
a third resistor connected to the shunt resistor at a third node;
a fourth resistor connected to the third resistor at a fourth node;
a first switch connected to the second resistor;
a second switch connected to the fourth resistor; and
a determination unit configured to receive a voltage of the second node and a voltage of the fourth node and to determine whether over-current flows in the shunt resistor.

### [ITEM 9]

The battery management apparatus of ITEM 8, wherein the determination unit comprises:
an amplifier configured to receive the voltage of the second node and the voltage of the fourth node and to amplify a difference therebetween;
a comparator configured to compare an output of the amplifier with a reference value; and
a controller configured to determine whether the charging over-current or the discharging over-current flows in the shunt resistor, based on the output of the amplifier or the comparator.

### [ITEM 10]

The battery management apparatus of ITEM 9, wherein the controller is configured to control the first switch and the second switch, to short-circuit the first switch and to open the second switch to detect the charging over-current, and to short-circuit the second switch and to open the first switch to detect the discharging over-current.

### [ITEM 11]

The battery management apparatus of ITEM 10, wherein the controller is configured to open both the first switch and the second switch in a situation where the battery is charged or discharged.

### [ITEM 12]

The battery management apparatus of ITEM 10, further comprising a relay connected to the shunt resistor,
wherein the relay is controlled by a control signal of the controller, and the controller is configured to open the relay when the first switch or the second switch is short-circuited.

### [ITEM 13]

The battery management apparatus of ITEM 9, wherein the first switch and the second switch comprise any one of a positive-negative-positive (PNP)-type bipolar junction transistor (BJT), a negative-positive-negative (NPN)-type BJT, and a metal-oxide-semiconductor field-effect transistor (MOSFET).

### [ITEM 14]

The battery management apparatus of ITEM 9, wherein magnitudes of the first resistor and the second resistor are set such that a difference between a magnitude of the voltage of the second node and a magnitude of the voltage of the battery corresponds to the magnitude of the voltage applied to the shunt resistor when the over-current flows during charging of the battery, and magnitudes of the third resistor and the fourth resistor are set such that a difference between a magnitude of the voltage of the fourth node and the magnitude of the voltage of the battery corresponds to the magnitude of the voltage applied to the shunt resistor when the over-current flows during discharging of the battery.

## Claims

1. A voltage generation apparatus connected to a shunt resistor (210) connected to a battery and outputting a voltage for determining whether an overcurrent flows through the shunt resistor, the voltage generation apparatus comprising:
a first resistor (R1) connected to the shunt resistor (210) at a first node (N1);
a third resistor (R3) connected to the shunt resistor (210) at a third node (N3);
a first circuit connected to a second node (N2) connected to the first resistor (R1) and a fourth node (N4) connected to the third resistor (R3); and
a second circuit connected to the first circuit;
wherein the voltage generation apparatus configured to output an output value of the second circuit to a determination unit (230) determining whether an overcurrent flows in the shunt resistor.

2. The voltage generation apparatus of claim 1, wherein the second circuit comprising:
a second resistor (R2) connected to the first resistor (R1) and the second node (N2);
a fourth resistor (R4) connected to the third resistor (R3) and the fourth node (N4);
a first switch (SW1) connected to the second resistor (R2); and
a second switch (SW2) connected to the fourth resistor (R4);
wherein the first switch (SW1) and the second switch (SW2) comprise any one of a negative-positive-negative (NPN) type bipolar junction transistor (BJT), a positive-negative-positive (PNP) type BJT, and a metal-oxide-semiconductor field-effect transistor (MOSFET).

3. The voltage generation apparatus of claim 2,
wherein magnitudes of the first resistor (R1) and the second resistor (R2) are set such that a difference between a magnitude of a voltage of the second node (N2) and a magnitude of a voltage of the battery corresponds to a magnitude of a voltage applied to the shunt resistor (210) when an overcurrent flows during charging of the battery, and
wherein magnitudes of the third resistor (R3) and the fourth resistor (R4) are set such that a difference between a magnitude of a voltage of the fourth node (N4) and a magnitude of a voltage of the battery corresponds to a magnitude of a voltage applied to the shunt resistor (210) when an overcurrent flows during discharging of the battery.

4. The voltage generation apparatus of claim 2 or 3,
wherein at least one of the first resistor, the second resistor, the third resistor and the fourth resistor consists of a plurality of resistors.

5. The voltage generation apparatus of claim 1, further comprising:
at least one switch (300) for controlling charging or discharging of the battery;
wherein determination of the overcurrent is performed in a state that the switch is turned off.

6. A battery management apparatus comprising:
A voltage generation apparatus according to any one of claims 1 to 5;
the shunt resistor; and
the determination unit.

7. A battery management method using the voltage generation apparatus according to any one of claims 2 to 5, the battery management method comprising:
shorting the first switch (SW1) and opening the second switch (SW2); and
opening the first switch (SW1) and shorting the second switch (SW2).
